# EUROPEAN PATENT APPLICATION

(11) **EP 4 672 371 A1**
(43) Date of publication of application: **31.12.2025**
(21) Application number: 23915181.4
(22) Date of filing: 08.03.2023
(51) Int. Cl.: H01M 4/38, H01M 4/62, B82Y 30/00, B82Y 40/00, C23C 16/26, C23C 16/30, C23C 16/455

(54) **FIBROUS SILICON-CARBON COMPOSITE MATERIAL AND PREPARATION METHOD THEREFOR**

(30) Priority: 22.02.2023 CN 202310152147
(71) Applicant: Shida Shingwa Advanced Material Group Co., Ltd., Dongying, Shandong 257503 (CN)
(72) Inventor: DING, Weitao, Shandong 257503 (CN); XING, Xianbo, Shandong 257503 (CN); LIU, Denghua, Shandong 257503 (CN); CHEN, Yingnan, Shandong 257503 (CN)
(74) Representative: Kurig, Thomas
(86) International application number: PCT/CN2023/080266
(87) International publication number: WO 2024/174293

(57) **Abstract**

The present invention discloses a fibrous silicon-carbon composite material and a preparation method therefor. The fibrous silicon-carbon composite material includes a core-shell structure, where a core of the core-shell structure includes a porous carbon fiber and nano-silicon, and a shell of the core-shell structure includes an inorganic lithium salt and amorphous carbon. The present invention has a characteristic of high electronic conductivity, and a lithium-ion battery to which the present invention is applied exhibits an excellent rate capability and excellent cycle performance.

## Description

The present application claims priority to Chinese Patent Application No. 2023101521471, filed with the China National Intellectual Property Administration on February 22, 2023 and entitled "FIBROUS SILICON-CARBON COMPOSITE MATERIAL AND PREPARATION METHOD THEREFOR", which is incorporated herein by reference in its entirety.

### TECHNICAL FIELD

The present invention pertains to the field of material preparation of lithium-ion batteries, and specifically, to a fibrous silicon-carbon composite material and a preparation method therefor.

### BACKGROUND

Silicon-carbon composite materials have advantages such as high specific capacities and wide material sources, and therefore, the silicon-carbon composite materials are widely used in lithium-ion batteries with high-energy-density. Currently, there are mainly two types of silicon-carbon composite materials in the market: a silicon-carbon composite material obtained according to a milling method and a silicon-carbon composite material obtained according to a silane pyrolysis method. The silicon-carbon composite material obtained according to a milling method has large silicon crystalline grains that are easily aggregated, resulting in high expansion and poor cycle performance of the material. In addition, a specific capacity and initial efficiency of the material are low (1250 mAh/g, 86%). The silicon-carbon composite material obtained according to a silane pyrolysis method has advantages such as small silicon crystalline grains, a high specific capacity and high initial efficiency (1900 mAh/g, 90%), low expansion, and good cycle performance, and therefore, the silicon-carbon composite material obtained according to a silane pyrolysis method becomes a novel material. However, the silicon-carbon composite material obtained according to a silane pyrolysis method is of a porous structure, although expansion is reduced, the porous structure reduces electronic conductivity of the material, and reduces a rate capability. Therefore, in current technology development, material doping and coating are one of main measures to improve a silicon-carbon material, that is, the material is coated with a material with high electronic conductivity and ionic conductivity to reduce an impedance of the material.

In this technical background, based on the dedicated research and development experience of the applicant's technical team in the field of silicon-carbon composite materials, the applicant hopes to seek a new technical path to obtain a silicon-carbon composite material with high efficiency performance.

### SUMMARY

In view of this, an objective of the present invention is to provide a fibrous silicon-carbon composite material and a preparation method therefor. The composite material has a characteristic of high electronic conductivity, and a lithium-ion battery to which the composite material is applied exhibits an excellent rate capability and excellent cycle performance.

Technical solutions of the present invention are as follows.

A fibrous silicon-carbon composite material is provided. The fibrous silicon-carbon composite material includes a core-shell structure, a core of the core-shell structure includes a porous carbon fiber and nano-silicon, and a shell of the core-shell structure includes an inorganic lithium salt and amorphous carbon.

Preferably, a mass percentage of the shell in the fibrous silicon-carbon composite material is 3 wt% to 20 wt%, more preferably, 5 wt% to 15 wt%.

Preferably, a preparation method for the foregoing fibrous silicon-carbon composite material is provided. The method includes at least the following operation steps:
step S1): dissolving polyacrylonitrile in an N,N-dimethylformamide solvent to obtain a spinning solution, and then performing electrostatic spinning to obtain a carbon nanofiber;
step S2): adding the carbon nanofiber obtained in step S1) to an alkali liquid, performing uniform mixing and spray drying, and performing heating and sintering in an inert atmosphere for at least 1 hour, to obtain a porous carbon fiber, wherein a mass ratio of the carbon nanofiber to the alkali liquid is 100: 100-300;
step S3): transferring the porous carbon fiber obtained in step S2) to a reaction chamber, introducing chlorosilane after vacuumizing, maintaining a pressure in the chamber to be 0.1 MPa to 1 MPa, performing pyrolysis at a condition of a temperature of 200°C to 400°C for at least 1 hour, and then performing cooling in the inert atmosphere, to obtain a nano-silicon-porous carbon fiber composite material; and
step S4): transferring the nano-silicon-porous carbon fiber composite material obtained in step S3) to a vacuum reaction chamber, first depositing lithium silicate on a surface through atomic vapor deposition, then transferring an obtained material to a carbonizing apparatus, and introducing a carbon source by using a vapor deposition method at a condition of a temperature of 700°C to 900°C to perform carbonizing processing for at least 1 hour, to obtain a nano-silicon-porous carbon fiber composite material coated with a layer of lithium silicate and a layer of amorphous carbon as the fibrous silicon-carbon composite material.

Preferably, in step S1), a mass concentration of the spinning solution is 10 wt% to 40 wt%; in step S2), the heating and sintering includes sintering for 1 hour to 6 hours at a condition of a temperature of 750°C to 850°C; in step S3), duration for the pyrolysis is 1 hour to 6 hours; and/or in step S4), duration for the carbonizing processing is 1 hour to 6 hours.

Preferably, in step S1), a spinning voltage of the electrostatic spinning is 15 kV to 20 kV, an injection speed is 0.1 mm/min to 0.5 mm/min, and a receiving distance is 15 cm to 20 cm.

Preferably, in step S1), the alkali liquid is any one or a mixture of more of sodium carbonate, sodium bicarbonate, potassium carbonate, and potassium bicarbonate, and/or a mass concentration of the alkali liquid is 1 wt% to 5 wt%.

Preferably, in step S3), chlorosilane is any one or a mixture of more of trichlorosilane, tetrachlorosilane, dimethylchlorosilane, propyltrichlorosilane, dimethylchlorosilane, allyltrichlorosilane, and phenyldichlorosilane.

Preferably, in step S4), atomic vapor deposition includes at least the following operation step:
transferring the nano-silicon-porous carbon fiber composite material obtained in step S3) to the vacuum chamber, using lithium silicate as a target material, vacuumizing the vacuum chamber and maintaining a pressure range of 0.05 Torr to 0.5 Torr, and after heating is performed to reach 280°C to 350°C, separately introducing lithium silicate and an oxygen source into the reaction chamber according to a set program to perform cyclic deposition, where the set program includes: introducing lithium silicate and performing nitrogen purging, introducing the oxygen source and performing nitrogen purging, and introducing water and performing nitrogen purging, and the program is performed cyclically for 10 to 100 times.

Preferably, in the set program, lithium silicate is introduced for 0.2 seconds to 1 second and nitrogen purging is performed for at least 30 seconds, the oxygen source is introduced for 2 seconds to 8 seconds and nitrogen purging is performed for at least 30 seconds, and water is introduced for 0.01 seconds to 0.06 seconds and nitrogen purging is performed for at least 30 seconds.

Preferably, in step S4), the carbon source is any one of methane, acetylene, ethylene, and ethane.

On the one hand, in the present application, the nano-silicon-porous carbon fiber composite material is obtained by depositing nano-silicon in a specific porous carbon fiber. Based on a porous structure of the porous carbon fiber and a fibrous carbon structure of the porous carbon fiber, after experimental verification, the applicant is pleasantly surprised to find that using this specific nano-silicon-porous carbon fiber composite material as a core structure of the carbonsilicon composite material can significantly reduce expansion of nano-silicon. In addition, the fibrous nano-silicon-porous carbon fiber composite material has a characteristic of high electronic conductivity, which can significantly improve a rate capability.

On the other hand, in the present application, lithium silicate is further deposited on the surface of the nano-silicon-porous carbon fiber composite material through atomic vapor deposition. The silicon-carbon composite material relies on a characteristic of high ionic conductivity of lithium silicate, and amorphous carbon located at an outer layer of lithium silicate further improves electronic conductivity of the silicon-carbon composite material, and avoids lithium silicate from being in direct contact with an electrolyte solution, thereby reducing side effects, and further improving initial efficiency and storage performance of the silicon-carbon composite material. Therefore, a synergistic effect of lithium silicate-amorphous carbon as a shell structure is implemented, and the rate capability, cycle performance, and high-temperature storage performance are improved.

### BRIEF DESCRIPTION OF DRAWINGS

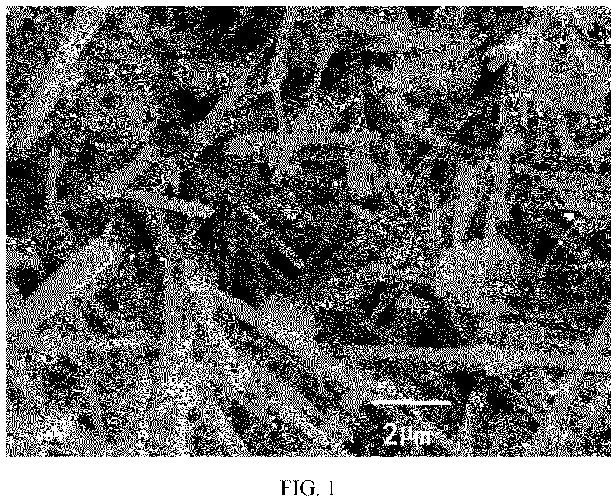

FIG. 1 shows an SEM graph of a silicon-carbon composite material prepared in Embodiment 1 of the present invention.

### DESCRIPTION OF EMBODIMENTS

An embodiment provides a fibrous silicon-carbon composite material. The fibrous silicon-carbon composite material includes a core-shell structure, where a core of the core-shell structure includes a porous carbon fiber and nano-silicon, and a shell of the core-shell structure includes an inorganic lithium salt and amorphous carbon. Preferably, in this implementation, a mass percentage of the shell in the fibrous silicon-carbon composite material is 3 wt% to 20 wt%, more preferably, 5 wt% to 15 wt%.

Preferably, an embodiment further provides a preparation method for the foregoing fibrous silicon-carbon composite material. The method includes at least the following operation steps:
Step S1): Dissolve polyacrylonitrile in an N,N-dimethylformamide solvent to obtain a spinning solution, and then perform electrostatic spinning to obtain a carbon nanofiber. Preferably, in step S1), a mass concentration of the spinning solution is 10 wt% to 40 wt%, more preferably, 10 wt% to 30 wt%; a spinning voltage of the electrostatic spinning is 15 kV to 20 kV, an injection speed is 0.1 mm/min to 0.5 mm/min, and a receiving distance is 15 cm to 20 cm; an alkali liquid is any one or a mixture of more of sodium carbonate, sodium bicarbonate, potassium carbonate, and potassium bicarbonate. Certainly, another suitable alkali liquid may alternatively be selected, and a mass concentration of the alkali liquid is 1 wt% to 5 wt%.
Step S2): Add the carbon nanofiber obtained in step S1) to the alkali liquid, perform uniform mixing and spray drying, and perform heating and sintering in an inert atmosphere for at least 1 hour (more preferably, perform sintering at a condition of a temperature of 750°C to 850°C for 1 hour to 6 hours), to obtain a porous carbon fiber, where a mass ratio of the carbon nanofiber to the alkali liquid is 100:100-300.
Step S3): Transfer the porous carbon fiber obtained in step S2) to a reaction chamber, introduce chlorosilane after vacuumizing, maintain a pressure in the chamber to be 0.1 MPa to 1 MPa, perform pyrolysis at a condition of a temperature of 200°C to 400°C for at least 1 hour (more preferably, duration for the pyrolysis is 1 hour to 6 hours), and then perform cooling in the inert atmosphere (preferably, perform cooling to reach a room temperature), to obtain a nano-silicon-porous carbon fiber composite material. Preferably, in step S3), chlorosilane is any one or a mixture of more of trichlorosilane, tetrachlorosilane, dimethylchlorosilane, propyltrichlorosilane, dimethylchlorosilane, allyltrichlorosilane, and phenyldichlorosilane. In this embodiment, a pyrolysis method is used for nano-silicon deposition with advantages such as a low temperature, weak activity, small silicon crystalline grains, and predicted uniform deposition.
Step 4): Transfer the nano-silicon-porous carbon fiber composite material obtained in step S3) to the vacuum reaction chamber, first deposit lithium silicate on a surface through atomic vapor deposition, then transfer an obtained material to a carbonizing apparatus, and introduce a carbon source (preferably, the carbon source is any one of methane, acetylene, ethylene, and ethane) by using a vapor deposition method (a well-known technology) at a condition of a temperature of 700°C to 900°C to perform carbonizing processing for at least 1 hour (more preferably, 1 hour to 6 hours), to obtain a nano-silicon-porous carbon fiber composite material coated with a layer of lithium silicate and a layer of amorphous carbon as the fibrous silicon-carbon composite material. Preferably, in step S4), atomic vapor deposition includes at least the following operation step:
   transferring the nano-silicon-porous carbon fiber composite material obtained in step S3) to the vacuum chamber, using lithium silicate as a target material, vacuumizing the vacuum chamber and maintaining a pressure range of 0.05 Torr to 0.5 Torr, and after heating is performed to reach 280°C to 350°C, separately introducing lithium silicate and an oxygen source into the reaction chamber according to a set program to perform cyclic deposition, where the set program includes: introducing lithium silicate and performing nitrogen purging, introducing the oxygen source and performing nitrogen purging, introducing water and performing nitrogen purging, and the program is performed cyclically for 10 to 100 times. Further preferably, in the set program, lithium silicate is introduced for 0.2 seconds to 1 second and nitrogen purging is performed for at least 30 seconds, the oxygen source is introduced for 2 seconds to 8 seconds and nitrogen purging is performed for at least 30 seconds, and water is introduced for 0.01 seconds to 0.06 seconds and nitrogen purging is performed for at least 30 seconds. Specifically, preferably, in the set program, lithium silicate is introduced for 0.5 seconds and nitrogen purging is performed for 60 seconds, the oxygen source is introduced for 5 seconds and nitrogen purging is performed for 5 seconds, and water is introduced for 0.03 seconds and nitrogen purging is performed for 50 seconds. Certainly, specific time parameters may alternatively be selected within a preferred set program range according to an actual implementation condition. This is not exclusively limited when the present application is implemented.

To enable a person skilled in the art to better understand the technical solutions in the present invention, the technical solutions in the embodiments of the present invention are clearly and completely described below with reference to the accompanying drawings in the embodiments of the present invention. Obviously, the described embodiments are merely some, rather than all, of the embodiments of the present invention. All other embodiments obtained by a person of ordinary skill in the art based on the embodiments of the present invention without creative efforts shall fall within the protection scope of the present invention.

Based on the foregoing described implementation solutions, the present application further provides the following specific embodiments:
**Embodiment** 1: Operations are performed according to the following steps:
Step S1): Dissolve 20 g of polyacrylonitrile in 100 g of N,N-dimethylformamide solvent to obtain a spinning solution with a mass concentration of 20 wt%, and then perform electrostatic spinning (a spinning voltage is 20 kV, an injection speed is 0.3 mm/min, and a receiving distance is 20 cm) to obtain a carbon nanofiber.
Step S2): Add 100 g of carbon nanofiber obtained in step S1) to 200 g of 2 wt% sodium carbonate aqueous solution, perform uniform mixing and spray drying, and perform sintering in an argon inert atmosphere at a condition of a temperature of 800°C for 3 hours, to obtain a porous carbon fiber.
Step S3): Transfer the porous carbon fiber obtained in step S2) to a reaction chamber, first perform vacuumizing to reach 0.1 Torr, then introduce trichlorosilane, maintain a pressure in the chamber to be 0.5 MPa, perform pyrolysis at a condition of a temperature of 300°C for 3 hours, and then perform cooling in the argon atmosphere to reach a room temperature, to obtain a nano-silicon-porous carbon fiber composite material.
Step S4): Transfer the nano-silicon-porous carbon fiber composite material obtained in step S3) to the vacuum reaction chamber, first deposit lithium silicate on a surface through atomic vapor deposition (a specific method includes: transferring the nano-silicon-porous carbon fiber composite material to the vacuum chamber, using lithium silicate as a target material, vacuumizing the vacuum chamber and maintaining a pressure of 0.1 Torr, and after heating is performed to reach 300°C, separately introducing lithium silicate and an oxygen source into the reaction chamber according to a set program to perform cyclic deposition, where the set program includes: introducing lithium silicate for 0.5 seconds and performing nitrogen purging for 60 seconds, introducing the oxygen source for 5 seconds and performing nitrogen purging for 5 seconds, and introducing water for 0.03 seconds and performing nitrogen purging for 50 seconds, and the program is performed cyclically for 50 times), then transfer an obtained material to a tube furnace (as a carbonizing apparatus), and introduce methane at a temperature of 800°C by using a vapor deposition method to perform carbonizing processing for 3 hours, to obtain a nano-silicon-porous carbon fiber composite material coated with a layer of lithium silicate and a layer of amorphous carbon as a fibrous silicon-carbon composite material in Embodiment 1.

In the present application, a scanning electron microscope (SEM) test is performed on the silicon-carbon composite material prepared in Embodiment 1. For a test result, refer to FIG. 1. It can be learned from FIG. 1 that the silicon-carbon composite material provided in Embodiment 1 is of a fibrous structure, and has a diameter of about 1 µm and a length between 20 µm and 100 µm.

**Embodiment 2:** Operations are performed according to the following steps:
Step S1): Dissolve 10 g of polyacrylonitrile in 100 g of N,N-dimethylformamide solvent to obtain a spinning solution with a mass concentration of 10 wt%, and then perform electrostatic spinning (a spinning voltage is 20 kV, an injection speed is 0.3 mm/min, and a receiving distance is 20 cm) to obtain a carbon nanofiber.
Step S2): Add 100 g of carbon nanofiber obtained in step S1) to 100 g of 5 wt% sodium carbonate aqueous solution, perform uniform mixing and spray drying, and perform sintering in an argon inert atmosphere at a condition of a temperature of 750°C for 6 hours, to obtain a porous carbon fiber.
Step S3): Transfer the porous carbon fiber obtained in step S2) to a reaction chamber, first perform vacuumizing to reach 0.1 Torr, then introduce trichlorosilane, maintain a pressure in the chamber to be 0.1 MPa, perform pyrolysis at a condition of a temperature of 200°C for 6 hours, and then perform cooling in the argon atmosphere to reach a room temperature, to obtain a nano-silicon-porous carbon fiber composite material.
Step S4): Transfer the nano-silicon-porous carbon fiber composite material obtained in step S3) to the vacuum reaction chamber, first deposit lithium silicate on a surface through atomic vapor deposition (a specific method includes: transferring the nano-silicon-porous carbon fiber composite material to the vacuum chamber, using lithium silicate as a target material, vacuumizing the vacuum chamber and maintaining a pressure of 0.1 Torr, and after heating is performed to reach 300°C, separately introducing lithium silicate and an oxygen source into the reaction chamber according to a set program to perform cyclic deposition, where the set program includes: introducing lithium silicate for 0.5 seconds and performing nitrogen purging for 60 seconds, introducing the oxygen source for 5 seconds and performing nitrogen purging for 5 seconds, and introducing water for 0.03 seconds and performing nitrogen purging for 50 seconds, and the program is performed cyclically for 10 times), then transfer an obtained material to a tube furnace (as a carbonizing apparatus), and introduce acetylene at a temperature of 900°C by using a vapor deposition method to perform carbonizing processing for 6 hours, to obtain a nano-silicon-porous carbon fiber composite material coated with a layer of lithium silicate and a layer of amorphous carbon as a fibrous silicon-carbon composite material in Embodiment 2.

**Embodiment 3:** Operations are performed according to the following steps:
Step S1): Dissolve 30 g of polyacrylonitrile in 100 g of N,N-dimethylformamide solvent to obtain a spinning solution with a mass concentration of 30 wt%, and then perform electrostatic spinning (a spinning voltage is 20 kV, an injection speed is 0.1 mm/min, and a receiving distance is 20 cm) to obtain a carbon nanofiber.
Step S2): Add 100 g of carbon nanofiber obtained in step S1) to 300 g of 1 wt% sodium carbonate aqueous solution, perform uniform mixing and spray drying, and perform sintering in an argon inert atmosphere at a condition of a temperature of 850°C for 1 hour, to obtain a porous carbon fiber.
Step S3): Transfer the porous carbon fiber obtained in step S2) to a reaction chamber, first perform vacuumizing to reach 0.1 Torr, then introduce trichlorosilane, maintain a pressure in the chamber to be 1 MPa, perform pyrolysis at a condition of a temperature of 400°C for 1 hour, and then perform cooling in the argon atmosphere to reach a room temperature, to obtain a nano-silicon-porous carbon fiber composite material.
Step S4): Transfer the nano-silicon-porous carbon fiber composite material obtained in step S3) to the vacuum reaction chamber, first deposit lithium silicate on a surface through atomic vapor deposition (a specific method includes: transferring the nano-silicon-porous carbon fiber composite material to the vacuum chamber, using lithium silicate as a target material, vacuumizing the vacuum chamber and maintaining a pressure of 0.1 Torr, and after heating is performed to reach 300°C, separately introducing lithium silicate and an oxygen source into the reaction chamber according to a set program to perform cyclic deposition, where the set program includes: introducing lithium silicate for 0.5 seconds and performing nitrogen purging for 60 seconds, introducing the oxygen source for 5 seconds and performing nitrogen purging for 5 seconds, and introducing water for 0.03 seconds and performing nitrogen purging for 50 seconds, and the program is performed cyclically for 100 times), then transfer an obtained material to a tube furnace (as a carbonizing apparatus), and introduce ethylene at a temperature of 900°C by using a vapor deposition method to perform carbonizing processing for 1 hour, to obtain a nano-silicon-porous carbon fiber composite material coated with a layer of lithium silicate and a layer of amorphous carbon as a fibrous silicon-carbon composite material in Embodiment 3.

**Comparative Example 1:** The remaining technical solutions of Comparative Example 1 are the same as those of Embodiment 1. A difference lies in that, in Comparative Example 1, step S1) and step S2) are canceled, and a well-known carbon fiber is used to replace the porous carbon fiber used in step S3).

**Comparative Example 2:** The remaining technical solutions of Comparative Example 2 are the same as those of Embodiment 1. A difference lies in that, in step S4) in Comparative Example 2, depositing lithium silicate on a surface through atomic vapor deposition is canceled, and a nano-silicon-porous carbon fiber composite material obtained in step S3) is directly transferred to a tube furnace (as a carbonizing apparatus), and methane is introduced at a temperature of 800°C by using a vapor deposition method to perform carbonizing processing for 3 hours.

**Comparative Example 3:** The remaining technical solutions of Comparative Example 3 are the same as those of Embodiment 1. A difference lies in that, in step S4) of Comparative Example 3, depositing amorphous carbon by using a vapor deposition method is canceled. A specific process includes: transferring a nano-silicon-porous carbon fiber composite material obtained in step S3) to a vacuum reaction chamber, first depositing lithium silicate on a surface through atomic vapor deposition (a specific method includes: transferring the nano-silicon-porous carbon fiber composite material to the vacuum chamber, using lithium silicate as a target material, vacuumizing the vacuum chamber and maintaining a pressure of 0.1 Torr, and after heating is performed to reach 300°C, separately introducing lithium silicate and an oxygen source into the reaction chamber according to a set program to perform cyclic deposition, where the set program includes: introducing lithium silicate for 0.5 seconds and performing nitrogen purging for 60 seconds, introducing the oxygen source for 5 seconds and performing nitrogen purging for 5 seconds, and introducing water for 0.03 seconds and performing nitrogen purging for 50 seconds, and the program is performed cyclically for 50 times).

**Comparative Example 4:** A silicon-carbon composite material provided in Embodiment 1 of a previously disclosed patent CN103305965A is used.

**Comparative Example 5:** Step S1), step S2), and step S3) are canceled, and the nano-silicon-porous carbon fiber composite material obtained through step S1), step S2), and step S3) in Embodiment 1 is replaced with a silicon-carbon composite material with a nanopore structure provided in Embodiment 1 of a previously disclosed patent CN103305965A, and step S4) is directly implemented.

To further compare and verify effects of the foregoing embodiments and comparative examples, in the present application, physical and chemical tests are performed on the silicon-carbon composite materials obtained in Embodiment 1 to Embodiment 3 and Comparative Example 1 to Comparative Example 5.

### 1. Button battery test:

The silicon-carbon composite materials obtained corresponding to Embodiment 1 to Embodiment 3 and Comparative Example 1 to Comparative Example 5 each are used as a cathode material of a lithium-ion battery to assemble a button battery. A preparation process of the button battery includes:
adding a binder, a conductive agent, and a solvent to the cathode material of the lithium-ion battery, performing mixing to prepare a slurry, coating the slurry on a copper foil, drying and laminating the copper foil to obtain a cathode sheet, where the binder used is polyvinylidene fluoride (PVDF), the conductive agent is conductive carbon black (SP), the solvent is N-methylpyrrolidone (NMP), and a dosage ratio of the silicon-carbon composite material to SP to PVDF to NMP is 95 g:1 g:4 g:220 mL; LiPF₆ in an electrolyte solution is an electrolyte, and a mixture of ethylene carbonate (EC) and diethyl carbonate (DEC) with a volume ratio of 1:1 is a solvent; a lithium metal sheet is used as a counter electrode, and a polypropylene (PP) film is used as a diaphragm; and assembly of the button battery is performed in a glovebox filled with argon.

The following electrochemical performance tests are performed on button batteries prepared corresponding to Embodiment 1 to Embodiment 3 and Comparative Example 1 to Comparative Example 5: A test is performed by using a CT2001A battery tester of WUHAN LAND, a charging/discharging voltage range is 0.005 V to 2.0 V, and a charging/discharging rate is 0.1 C. A four-probe tester is further used to test powder conductivity of each of the silicon-carbon composite materials corresponding to Embodiment 1 to Embodiment 3 and Comparative Example 1 to Comparative Example 5, and a particle size, a specific surface area, and tap density are tested according to the national standard GBT-38823-2020 "Silicon-Carbon". For test results, refer to Table 1.

**Table 1**

| | Initial specific discharge capacity (mAh/g) | Initial efficiency (%) | Particle size (µm) | Specific surface area (m²/g) | Tap density (g/cm³) | Powder conductivity (S/cm) |
|---|---|---|---|---|---|---|
| Embodiment 1 | 1895.4 | 87.9 | 5.8 | 5.2 | 0.98 | 2.81 |
| Embodiment 2 | 1884.4 | 87.5 | 5.8 | 5.1 | 0.96 | 2.56 |
| Embodiment 3 | 1865.2 | 87.1 | 6.2 | 4.9 | 0.95 | 2.44 |
| Comparative Example 1 | 1656.4 | 88.1 | 7.7 | 2.9 | 0.92 | 2.12 |
| Comparative Example 2 | 1568.5 | 83.1 | 7.9 | 1.9 | 0.85 | 0.98 |
| Comparative Example 3 | 1612.4 | 85.8 | 8.1 | 2.3 | 0.86 | 0.37 |
| Comparative Example 4 | 1490.4 | 86.1 | 8.2 | 2.4 | 0.81 | 0.19 |
| Comparative Example 5 | 1519.9 | 86.8 | 8.3 | 2.6 | 0.83 | 0.27 |

It can be learned from the data in Table 1 that the specific capacities and the initial efficiency of the silicon-carbon composite materials prepared in Embodiment 1 to Embodiment 3 of the present application are obviously better than those of the silicon-carbon composite materials prepared in Comparative Example 1 to Comparative Example 5. A main reason is that the porous carbon fiber has characteristics of lower expansion and a higher specific surface area than a carbon fiber material. Therefore, expansion is reduced. In addition, coating lithium silicate on the surface of the porous carbon fiber can reduce an irreversible capacity loss of the silicon-carbon composite material, thereby improving the initial efficiency of the material.

### 2. Pouch battery test:

The silicon-carbon composite materials corresponding to Embodiment 1 to Embodiment 3 and Comparative Example 1 to Comparative Example 5 each are doped with 90% artificial graphite, an obtained material is used as a cathode material to prepare a cathode sheet, and NCM532 is used as an anode material, where LiPF₆ in an electrolyte solution is an electrolyte, and a mixture of EC and DEC with a volume ratio of 1:1 is a solvent; a Celgard 2400 film is used as a diaphragm to prepare a pouch battery of 5 Ah; and electrolyte adsorption and electrolyte retention capabilities of the cathode sheets, cathode sheet full-charge rebound performance, and cycle performance are separately tested. Specific tests are as follows:
a. Electrolyte adsorption capability test: drawing up 1 mL of electrolyte solution by using a 1 mL burette, adding the electrolyte solution on a surface of the cathode sheet dropwise, performing timing until the electrolyte solution is completely absorbed, recording a time t, and calculating an electrolyte adsorption speed V/t of the cathode sheet. For test results, refer to Table 2.
b. Electrolyte retention rate test: calculating a theoretical electrolyte absorption amount m1 of the cathode sheet based on a parameter of the cathode sheet, weighing a weight m2 of the cathode sheet, then placing the cathode sheet in the electrolyte solution to soak for 24 h, weighing a weight m3 of the cathode sheet, calculating an electrolyte absorption amount m3-m2 of the cathode sheet, and performing calculation according to the following formula:
   electrolyte retention rate = (m3 - m2) * 100%/ml. For test results, refer to Table 2.

**Table 2**

| | Electrolyte absorption speed | Electrolyte retention rate |
|---|---|---|
| Embodiment 1 | 45 | 89.0% |
| Embodiment 2 | 51 | 88.1% |
| Embodiment 3 | 56 | 87.4% |
| Comparative Example 1 | 89 | 83.7% |
| Comparative Example 2 | 116 | 80.9% |
| Comparative Example 3 | 97 | 81.7% |
| Comparative Example 4 | 104 | 82.1% |
| Comparative Example 5 | 110 | 82.7% |

It can be learned from Table 2 that the electrolyte absorption and electrolyte retention capabilities of the silicon-carbon composite materials obtained in Embodiment 1 to Embodiment 3 are obviously better than those of the silicon-carbon composite materials of Comparative Example 1 to Comparative Example 5. The experimental results indicate that the silicon-carbon composite material provided in the present application has good electrolyte absorption and electrolyte retention capabilities, and a reason may be that the silicon-carbon composite material provided in the present application has a high specific surface area, thereby improving the electrolyte absorption and electrolyte retention capabilities of the material.
c. Cathode sheet full-charge rebound rate test: first using a thickness tester to test an average thickness D1 for cathode sheet rolling, then charging the pouch battery to 4.2 V, dissecting the battery, taking out the cathode sheet to test a thickness D2 of the cathode sheet, and performing calculation according to the following formula:
cathode sheet full-charge rebound rate = (D2 - D1) * 100%/D1. For test results, refer to Table 3.

**Table 3**

| | Cathode sheet full-charge rebound rate (%) |
|---|---|
| Embodiment 1 | 35.3 |
| Embodiment 2 | 36.6 |
| Embodiment 3 | 37.6 |
| Comparative Example 1 | 41.4 |
| Comparative Example 2 | 45.5 |
| Comparative Example 3 | 42.8 |
| Comparative Example 4 | 75.9 |
| Comparative Example 5 | 66.8 |

It can be learned from the data in Table 3 that the full-charge rebound rates of the cathode sheets made of the silicon-carbon composite materials obtained in Embodiment 1 to Embodiment 3 are less than those of the cathode sheets made of the silicon-carbon composite materials of Comparative Example 1 to Comparative Example 5, that is, the cathode sheet made of the silicon-carbon composite material of the present invention has a low cathode sheet full-charge rebound rate. A reason may be that expansion is reduced by using a porous structure of the porous carbon fiber and a fibrous carbon structure of the porous carbon fiber.
d. Cycle performance test: testing the cycle performance of the battery at a temperature of 25°C±3°C with a charging/discharging rate of 1 C/1 C and a voltage range of 2.5 V to 4.2 V. For test results, refer to Table 4.

**Table 4**

| | Capacity retention rate (%) after 500 cycles |
|---|---|
| Embodiment 1 | 92.12 |
| Embodiment 2 | 91.28 |
| Embodiment 3 | 90.29 |
| Comparative Example 1 | 87.55 |
| Comparative Example 2 | 85.3% |
| Comparative Example 3 | 86.9% |
| Comparative Example 4 | 82.9% |
| Comparative Example 5 | 83.6% |

It can be learned from Table 4 that the cycle performance of the batteries prepared by using the silicon-carbon composite materials provided in the present application is obviously better than that of the batteries prepared by using the silicon-carbon composite materials of Comparative Example 1 to Comparative Example 5. A main reason is that the cathode sheet made of the silicon-carbon composite material provided in the present application has a low expansion rate, and a structure of the cathode sheet is more stable in a charging and discharging process, thereby improving cycle performance of the battery. In addition, lithium silicate is deposited on a nano-silicon-carbon fiber surface of the silicon-carbon composite material through atomic vapor deposition. Therefore, cycle performance of the battery can be further improved based on a characteristic of high ionic conductivity of lithium silicate.

It will be clear to a person skilled in the art that the present invention is not limited to the details of the foregoing example embodiments, and the present invention can be implemented in other specific forms without departing from the essential features of the present invention. Therefore, the embodiments should be regarded in all respects as examples rather than as restrictive, and the scope of the present invention is defined by the appended claims rather than the foregoing descriptions. Therefore, all changes falling within the meanings and scope of equivalent elements of the claims are included in the present invention. Any reference numeral in the claims shall not be construed as limiting the claims.

In addition, it should be understood that, although this specification has been described with reference to embodiments, not every embodiment includes only one independent technical solution, and such description of this specification is by way of clarity only. A person skilled in the art should take this specification as a whole, and the technical solutions of the embodiments may be combined as appropriate to obtain other embodiments that can be understood by a person skilled in the art.

## Claims

1. A fibrous silicon-carbon composite material, wherein the fibrous silicon-carbon composite material comprises a core-shell structure, a core of the core-shell structure comprises a porous carbon fiber and nano-silicon, and a shell of the core-shell structure comprises an inorganic lithium salt and amorphous carbon.

2. The fibrous silicon-carbon composite material according to claim 1, wherein a mass percentage of the shell in the fibrous silicon-carbon composite material is 3 wt% to 20 wt%, more preferably, 5 wt% to 15 wt%.

3. A preparation method for the fibrous silicon-carbon composite material according to one of claims 1 to 2, comprising at least the following operation steps:
step S1): dissolving polyacrylonitrile in an N,N-dimethylformamide solvent to obtain a spinning solution, and then performing electrostatic spinning to obtain a carbon nanofiber;
step S2): adding the carbon nanofiber obtained in step S1) to an alkali liquid, performing uniform mixing and spray drying, and performing heating and sintering in an inert atmosphere for at least 1 hour, to obtain a porous carbon fiber, wherein a mass ratio of the carbon nanofiber to the alkali liquid is 100: 100-300;
step S3): transferring the porous carbon fiber obtained in step S2) to a reaction chamber, introducing chlorosilane after vacuumizing, maintaining a pressure in the chamber to be 0.1 MPa to 1 MPa, performing pyrolysis at a condition of a temperature of 200°C to 400°C for at least 1 hour, and then performing cooling in the inert atmosphere, to obtain a nano-silicon-porous carbon fiber composite material; and
step S4): transferring the nano-silicon-porous carbon fiber composite material obtained in step S3) to a vacuum reaction chamber, first depositing lithium silicate on a surface through atomic vapor deposition, then transferring an obtained material to a carbonizing apparatus, and introducing a carbon source by using a vapor deposition method at a condition of a temperature of 700°C to 900°C to perform carbonizing processing for at least 1 hour, to obtain a nano-silicon-porous carbon fiber composite material coated with a layer of lithium silicate and a layer of amorphous carbon as the fibrous silicon-carbon composite material.

4. The preparation method according to claim 3, wherein in step S1), a mass concentration of the spinning solution is 10 wt% to 40 wt%; in step S2), the heating and sintering comprises sintering for 1 hour to 6 hours at a condition of a temperature of 750°C to 850°C; in step S3), duration for the pyrolysis is 1 hour to 6 hours; and/or in step S4), duration for the carbonizing processing is 1 hour to 6 hours.

5. The preparation method according to claim 3, wherein in step S1), a spinning voltage of the electrostatic spinning is 15 kV to 20 kV, an injection speed is 0.1 mm/min to 0.5 mm/min, and a receiving distance is 15 cm to 20 cm.

6. The preparation method according to claim 3, wherein in step S1), the alkali liquid is any one or a mixture of more of sodium carbonate, sodium bicarbonate, potassium carbonate, and potassium bicarbonate, and/or a mass concentration of the alkali liquid is 1 wt% to 5 wt%.

7. The preparation method according to claim 3, wherein in step S3), chlorosilane is any one or a mixture of more of trichlorosilane, tetrachlorosilane, dimethylchlorosilane, propyltrichlorosilane, dimethylchlorosilane, allyltrichlorosilane, and phenyldichlorosilane.

8. The preparation method according to claim 3, wherein in step S4), atomic vapor deposition comprises at least the following operation step:
transferring the nano-silicon-porous carbon fiber composite material obtained in step S3) to the vacuum chamber, using lithium silicate as a target material, vacuumizing the vacuum chamber and maintaining a pressure range of 0.05 Torr to 0.5 Torr, and after heating is performed to reach 280°C to 350°C, separately introducing lithium silicate and an oxygen source into the reaction chamber according to a set program to perform cyclic deposition, wherein the set program comprises: introducing lithium silicate and performing nitrogen purging, introducing the oxygen source and performing nitrogen purging, and introducing water and performing nitrogen purging, and the program is performed cyclically for 10 to 100 times.

9. The preparation method according to claim 8, wherein in the set program, lithium silicate is introduced for 0.2 seconds to 1 second and nitrogen purging is performed for at least 30 seconds, the oxygen source is introduced for 2 seconds to 8 seconds and nitrogen purging is performed for at least 30 seconds, and water is introduced for 0.01 seconds to 0.06 seconds and nitrogen purging is performed for at least 30 seconds.

10. The preparation method according to claim 3, wherein in step S4), the carbon source is any one of methane, acetylene, ethylene, and ethane.
